# EUROPÄISCHE PATENTANMELDUNG

(11) **EP 1 335 009 A1**
(43) Veröffentlichungstag der Anmeldung: **13.08.2003**
(21) Anmeldenummer: 02024336.6
(22) Anmeldetag: 02.11.2002
(51) Int. Cl.: C09G 1/02, C09K 3/14, C01B 33/26, H01L 21/306

(54) **Dispersion zum chemisch-mechanischen Polieren**

(30) Priorität: 07.02.2002 DE 10205280
(71) Anmelder: Degussa AG, 40474 Düsseldorf (DE)
(72) Erfinder: Die Erfindernennung liegt noch nicht vor

(57) **Zusammenfassung**

Wässerige Dispersion zum chemisch-mechanischen Polieren von oxidischen Oberflächen, welche ein Pulver aus mittels eines Aerosols mit Aluminiumoxid dotiertem pyrogen hergestelltem Siliciumdioxid enthält, die dadurch gekennzeichnet ist, dass das Pulver einen Aluminiumoxidgehalt zwischen 0,01 und 3 Gew.-%, bevorzugt zwischen 0,2 und 1,5 Gew.-%, bezogen auf die Gesamtmenge des Pulvers, und einen mittleren Teilchendurchmesser in der Dispersion von maximal 0,1 µm aufweist. Die Dispersion wird durch Dispergierung des mittels eines Aerosols mit Aluminiumoxid dotierten Siliciumdioxidpulvers mit einem Energieeintrag von mindestens 200 KJ/m³ in einem wässerigem Medium hergestellt. Die Dispersion findet Verwendung zum chemisch-mechanischen Polieren von oxidischen Oberflächen, bevorzugt Siliciumdioxid.

## Beschreibung

Die Erfindung betrifft eine wässerige Dispersion zum chemisch-mechanischen Polieren von oxidischen Oberflächen und ein Verfahren zu ihrer Herstellung.

Siliciumdioxid enthaltende wässerige Dispersionen finden einen breiten Anwendungsbereich. Die Anwendungen umfassen zum Beispiel das Coating von Papier, die Herstellung von Glasfasern und Quarzglas, sowie das chemisch-mechanische Polieren von Halbleitersubstraten (CMP-Prozeß).

Übliche Dispersionen gehen meist von kolloidalem Siliciumdioxid, den Kiesel-Solen, oder von pyrogen hergestelltem Siliciumdioxid aus.

Dispersionen, welche kolloidales Siliciumdioxid enthalten, weisen in der Regel eine definierte, kleine Teilchengröße und eine gute Dispersionsstabilität auf. Beim chemisch-mechanischen Polieren ist die Defektrate, zum Beispiel die Anzahl der Kratzer, auf der polierten Oberfläche gering. Nachteilig ist jedoch, die im Vergleich zu Dispersionen, die pyrogen hergestelltes Siliciumdioxid enthalten, geringe Abtragsrate beim Polieren oxidischer Oberflächen.

Dispersionen die pyrogen hergestelltes Siliciumdioxid enthalten, verursachen wiederum eine größere Anzahl von Kratzern, hervorgerufen durch Aggregation und Agglomeration von Primärteilchen, wobei harte Partikel entstehen. Die Dispergierung der Aggregate und Agglomerate erweist sich als schwierig, die Dispersionen sind weniger stabil und neigen zur Sedimentation oder auch zum Gelieren.

EP-A-1148026 beschreibt eine Dispersion von mittels Aerosol mit Aluminiumoxid dotiertem Siliciumdioxid und die Verwendung dieser Dispersion zur Herstellung von Streichfarben im ink-jet-Bereich und zum chemisch-mechanischen Polieren. Beansprucht wird eine wässerige Dispersion mit einem sehr breiten Bereich der Aluminiumoxid-Dotierung von 1 bis 200 000 ppm. Es wurde jedoch gefunden, dass eine so definierte Dispersion zwar im ink-jet-Bereich vorteilhaft eingesetzt werden kann, beim chemisch-mechanischen Polieren jedoch kein befriedigendes Polierverhalten zeigt. So weist eine nach EP-A-1148026 hergestellte Dispersion, die ein mit 20 Gew.-% Aluminiumoxid dotiertes Siliciumdioxidpulver enthält, eine sehr hohe Defektrate auf, während niedrig dotiertes Pulver, zum Beispiel mit 10 ppm Aluminiumoxid, eine geringe Abtragsrate zeigt.

Aufgabe der Erfindung ist es eine Dispersion bereitzustellen, die beim chemisch mechanischen Polieren von oxidischen Oberflächen eine hohe Abtragsrate erlaubt ohne Kratzer auf den zu polierenden Oberflächen zu hinterlassen.

Gegenstand der Erfindung ist eine wässerige Dispersion zum chemisch-mechanischen Polieren von oxidischen Oberflächen, enthaltend ein Pulver aus mittels eines Aerosols mit Aluminiumoxid dotiertem pyrogen hergestelltem Siliciumdioxid, welche dadurch gekennzeichnet ist, dass das Pulver einen Aluminiumoxidgehalt zwischen 0,01 und 3 Gew.-%, bevorzugt zwischen 0,2 und 1,5 Gew.-%, bezogen auf die Gesamtmenge des Pulvers, und einen mittleren Teilchendurchmesser in der Dispersion von maximal 0,1 µm aufweist.

Die Herstellung des Pulvers erfolgt nach EP-A-995718.

Der mittlere Teilchendurchmesser in der Dispersion kann zum Beispiel durch dynamische Lichtstreuung bestimmt werden. Für die erfindungsgemäße Dispersion ist sowohl der anzahlbezogene wie auch der volumenbezogene mittlere Teilchendurchmesser kleiner als 0,1 µm.

Die erfindungsgemäße Dispersion zeigt beim chemisch-mechanischen Polieren von oxidischen Oberflächen eine sehr gute Abtragsrate ohne Kratzer zu erzeugen. Wesentliches Merkmal der Erfindung ist, dass der Aluminiumoxidgehalt des dotierten Siliciumdioxidpulvers zwischen 0,01 und 3 Gew.-% liegt, und die mittlere Teilchengröße in der Dispersion. Bei Aluminiumoxidgehalten kleiner als 0,01 Gew.-% ist nur eine geringe Abtragsrate zu beobachten, während bei Dotierungen von mehr als 3 Gew.-% die Anzahl der Kratzer beim Polieren deutlich zunimmt. Beide Aussagen beziehen sich auf Pulver mit einer mittleren Teilchengröße in der Dispersion von weniger als 0,1 µm. Ebenso nimmt die Anzahl der Kratzer bei einer mittleren Teilchengröße in der Dispersion von mehr als 0,1 µm deutlich zu.

Die erfindungsgemäße Dispersion kann einen pH-Wert von 8,5 bis 11 aufweisen. Die Einstellung des pH-Wertes kann erfolgen durch Alkalihydroxid, bevorzugt Kalilauge, Ammoniak beziehungsweise Ammoniumhydroxidlösung, oder Amine oder Tetraalkylammoniumsalze, wie zum Beispiel Tetramethylammoniumhydroxid. Weiterhin können Puffersysteme zur Stabilisierung des pH-Wertes eingesetzt werden.

Der Gehalt des Pulvers in der erfindungsgemäßen Dispersion kann zwischen 5 und 50 Gew.-%, bevorzugt grösser als 10 Gew.-%, liegen.

Die BET-Oberfläche des Pulvers in der erfindungsgemäßen Dispersion kann bevorzugt zwischen 50 und 90 m²/g liegen.

Um die erfindungsgemäße Dispersion gegen Absetzen und Ausflockungen zu stabilisieren können ihr Additive wie oberflächenaktive Stoffe und Dispergierhilfsmittel zugesetzt werden. Die oberflächenaktiven Stoffe können anionischer, kationischer, nichtionischer, amphoterer Natur sein oder Mischungen hieraus. Die Menge richtet sich nach der einzelnen oberflächenaktiven Substanz und kann zwischen 0,001 und 2 Gew.-% variieren. Beispielsweise können Natriumdodecylsulfat, Natriumlaurylsulfat, Ammoniumdodecylsulfat und Mischungen hieraus verwendet werden.

Ein weiterer Gegenstand der Erfindung ist ein Verfahren zur Herstellung der erfindungsgemäßen Dispersion, welches dadurch gekennzeichnet ist, dass man mittels eines Aerosols mit Aluminiumoxid dotiertes Siliciumdioxid in einem wässerigem Medium mit einem Energieeintrag von mindestens 200 KJ/m³ dispergiert.

Als geeignete Systeme mit denen dieser Energieeintrag möglich ist zählen zum Beispiel Systeme nach dem Rotor-Stator-Prinzip, zum Beispiel Ultra-Turrax-Maschinen, oder Rührwerkskugelmühlen. Höhere Energieeinträge sind mit einem Planetenkneter/-mixer möglich. Ein solches System wird bevorzugt bei Dispersionen mit hoher Viskosität angewendet, die nötig ist um die hohen Scherenergien zum Zerteilen der Teilchen einzubringen.

Bevorzugt können Hochdruckhomogenisatoren zur Herstellung der erfindungsgemäßen Dispersion verwendet werden. Bei diesen Vorrichtungen werden zwei unter hohem Druck stehende vordispergierte Suspensionsströme über eine Düse entspannt. Beide Dispersionsstrahlen treffen exakt aufeinander und die Teilchen mahlen sich selbst. Bei einer anderen Ausführungsform wird die Vordispersion ebenfalls unter hohen Druck gesetzt, jedoch erfolgt die Kollision der Teilchen gegen gepanzerte Wandbereiche. Die Operation kann beliebig oft wiederholt werden um kleinere Teilchengrößen zu erhalten.

Ein weiterer Gegenstand der Erfindung ist die Verwendung der erfindungsgemäßen Dispersion zum chemisch-mechanischen Polieren von oxidischen Oberflächen, bevorzugt Siliciumdioxid.

### Beispiele

### Analysenverfahren

**Partikelgrößen:** Die mittlere Teilchengrösse in der Dispersion wurde mit dem Zetasizer 3000 Hsa der Firma Malvern bestimmt.

**BET-Oberfläche:** Die Oberfläche der eingesetzten Pulver wurde nach DIN 66131 bestimmt.

**Viskosität:** Die Viskosität der erzeugten Dispersionen wurde mit einem Rotations-Rheometer der Firma Physica Model MCR 300 und dem Meßbecher CC 27 ermittelt. Der Viskositätswert wurde bei einer Schergeschwindigkeit von 500 1/sec. ermittelt. Diese Schergeschwindigkeit liegt in einem Bereich, in dem die Viskosität praktisch unabhängig von der Scherbeanspruchung ist.

**Bodensatz:** Die Beurteilung einer Bodensatzbildung erfolgte durch visuelle Beurteilung in einer 1000 ml Weithals-Polyethylen-Flasche nach einer Standzeit von einer Woche. Durch vorsichtiges Kippen der Flasche kann leicht ein gegebenenfalls vorhandener Bodensatz erkannt werden.

**Abtragsleistung und Non-Uniformity:** Die mit den Dispersionen erzielten Abtragsleistungen und die Non-Uniformity werden durch Messungen der Schichtdicke mit einem Axiospeed Spektralphotometer von Zeiss ermittelt. Es wurden Line-Scan Messungen auf dem Wafer mit jeweils 6mm Randausschluß durchgeführt. Für die Bestimmung der mittlere Abtragsrate wurden jeweils 25 Wafer poliert und ausgewertet.

**Defekte:** Die Untersuchungen bezüglich Defekten (Kratzer und Partikel) erfolgten visuell unter einer Haze-Lampe beziehungsweise mit einem Censor ANS 100 Oberflächenpartikelzähler.

### Pulver

Mit 0,25 Gew.-% Aluminiumoxid dotiertes Siliciumdioxidpulver P1 und mit 8 Gew.-% Aluminiumoxid dotiertes Siliciumdioxidpulver P2 wurden hergestellt nach EP-A-995718. P1 besitzt eine BET-Oberfläche von 55 m²/g, P2 eine von 63 m²/g.

### Dispersionen

**D1:** In einem 60 1 Edelstahl-Ansatzbehälter werden 36 kg VE-Wasser und 104 g 30%ige KOH-Lösung vorgelegt. Mit Hilfe eines Dispergier- und Saugmischers der Firma Ystral (bei 4500 UpM) werden 16,5 kg des Pulvers P1 eingesaugt und grob vordispergiert. Nach dem Pulvereintrag wird die Dispergierung mit einem Rotor/Stator Durchlaufhomogenisator Typ Z 66 der Firma Ystral mit vier Bearbeitungskränzen, einer Statorschlitzbreite von 1 mm und einer Drehzahl von 11 500 UpM vervollständigt. Während dieser 15 minütigen Dispergierung mit 11 500 UpM wird der pH-Wert durch Zugabe von weiterer KOH-Lösung auf einen pH-Wert von 10,5 eingestellt und gehalten. Hierbei wurden weitere 779 g KOH-Lösung verwendet und durch Zugabe von 1,5 kg Wasser eine Feststoffkonzentration von 30 Gew.-% eingestellt. Die so erhaltene Dispersion wird mit einem Hochdruckhomogenisator, Ultimaizer System der Firma Sugino Machine Ltd., Modell HJP-25050, bei einem Druck von 250 MPa und einem Diamantdüsendurchmesser von 0,3 mm und zwei Mahl-Durchgängen vermahlen.

**D2 und D3:** Analog wird aus dem Pulver P2 die Dispersion D2 und aus Aerosil 130(BET-Oberfläche 130 m²/g), der Fa. Degussa AG, mit der Bezeichnung P3, eine Dispersion D3 hergestellt.

Weitere analytische Daten dieser Dispersionen sind in Tabelle 1 aufgeführt.

**Tabelle 1:**

| **Analytische Daten der Dispersionen D1 bis D3**^{**(1)**} | | | | |
|---|---|---|---|---|
| | **mittl. Teilchendurch- messer in der Dispersion** | | | |
| **Dispersion** | **Anzahl** [nm] | **Volumen** [nm] | **Viskosität**^{**(2)**} [mPas] | **Boden- satz** |
| D1 | 62 | 78 | 4 | nein |
| D2 | 87 | 99 | 5 | nein |
| D3 | 100 | 140 | 15 | nein |

| | | | | |
|---|---|---|---|---|
| (1) Feststoffgehalt 30 Gew.-%, pH 10,5; (2) bei 500 1/sec | | | | |

Neben den Dispersionen D1 bis D3 werden auch folgende kommerziell erhältlichen Dispersionen zum Polieren eingesetzt:
D4: Klebosol 30N50 (Fa. Rodel), Feststoffgehalt 30 Gew.-%, stabilisiert mit Ammoniak, pH 9,5
D5: Klebosol 1501 (Fa. Rodel), Feststoffgehalt 30 Gew.-%, stabilisiert mit KOH, pH 10,9
D6: Semi-Sperse 25 (Cabot Microelectronics), Feststoffgehalt 25 Gew.-%, KOH stabilisiert, pH 11,0, mit Wasser 1:1 verdünnt.

### Polierprozeß

**Ausrüstung:** Für die Poliertests wurde ein P200 CMP Clustertool von Peter Wolters CMP Systeme, ausgestattet mit einer PM200 Poliermaschine und einem Bürstenreiniger der Firma Contrade, verwendet. Reinigungsversuche erfolgten mit Wasser bzw. mit Ammoniak.

Der Polierkopf war mit einem DF200 Backingfilm von Rodel bestückt, als Poliertuch wurde ein IC1000/SubaIV Pad, ebenfalls von Rodel eingesetzt. Für den Polierprozess wurde der in Tabelle 2 aufgeführte Parametersatz verwendet.

**Tabelle 2:**

| **Parametersatz des Polierprozesses**^{**1)**} | |
|---|---|
| Kraft | 1500 N |
| Aufsetzpunkt ²⁾ | 190 mm |
| Rückseitendruck innen ³⁾ | 0 kPa |
| Rückseitendruck außen ³⁾ | 10 kPa |
| Oszillation | - 10 mm |
| Chuckgeschwindigkeit | 20 U/min |
| Poliertellergeschwindigkeit | 33 U/min |
| Dispersionsfluß | 180 ml/min |
| Polierzeit | 60 sec |

| | |
|---|---|
| 1)Temperatur: ca. 25°C; | |
| 2)Angabe in mm Abstand Chuckmitte von Polierteller-Mitte (Ø Polierteller 600mm); | |
| 3) Es wurde ein Zweizonenchuck verwendet, wo zur besseren Einstellung der Uniformity zwei Bereiche getrennt mit Rückseitendruck beaufschlagt werden können; | |

**Wafer:** 200mm Si-Wafer, beschichtet mit 1000nm LPCVD TEOS (670 °C, 750 mTorr).

### Polierergebnisse

Die erfindungsgemäße Dispersion mit 0,25 Gew.-% Aluminiumoxid dotiertem Siliciumdioxidpulver mit einer mittleren Partikelgröße von kleiner als 0,1 µm enthält zeigt beim Polieren Vorteile bezüglich Abtragsrate und Non-Uniformity gegenüber den untersuchten Dispersionen auf Basis von kolloidalem Siliciumdioxid, Klebosol 30N50 (D4) und 1501 (D5), und gegenüber der SS25-Dispersion (D6) auf Basis von pyrogenem Siliciumdioxid. D2 zeigt von allen untersuchten Dispersionen die höchste Abtragsrate, ist jedoch aufgrund der hohen Anzahl an Defekten zum Polieren von oxidischen Schichten nicht geeignet.

Die Bestimmung der Defekte nach der Post-CMP-Reinigung ergibt für alle untersuchten Dispersionen, mit Ausnahme von D2, ähnliche Werte (Tabelle 3).

**Tabelle 3:**

| **Polierergebnisse Line-Scan Messung(1)** | | | | | | |
|---|---|---|---|---|---|---|
| **Dispersion** | **D1** | **D2** | **D3** | **D4** | **D5** | **D6** |
| Abtrag (nm/min) | 459 | 493 | 355 | 287 | 326 | 353 |
| Non-Uniformity⁽²⁾ (%) | 5,2 | 7,1 | 6,7 | 5,3 | 6,2 | 5,9 |
| Defekte⁽³⁾ | 185 | 513 | 176 | 171 | 178 | 176 |

| | | | | | | |
|---|---|---|---|---|---|---|
| (l)Randausschluß 6 mm; | | | | | | |
| (2)Standardabw. 1 Sigma; | | | | | | |
| (3)Partikelgröße 0,25 - 1,00 µm, Brushclean mit 2% Ammoniak; | | | | | | |

## Patentansprüche

1. Wässerige Dispersion zum chemisch-mechanischen Polieren von oxidischen Oberflächen, enthaltend ein Pulver aus mittels eines Aerosols mit Aluminiumoxid dotiertem pyrogen hergestelltem Siliciumdioxid, **dadurch gekennzeichnet, dass** das Pulver einen Aluminiumoxidgehalt zwischen 0,01 und 3 Gew.-%, bevorzugt zwischen 0,2 und 1,5 Gew.-%, bezogen auf die Gesamtmenge des Pulvers, und einen mittleren Teilchendurchmesser in der Dispersion von maximal 0,1 µm aufweist.

2. Wässerige Dispersion nach Anspruch 1, **dadurch gekennzeichnet, dass** sie einen pH-Wert von 8,5 bis 11 aufweist.

3. Wässerige Dispersion nach den Ansprüchen 1 oder 2, **dadurch gekennzeichnet, dass** der Gehalt des Pulvers in der Dispersion zwischen 5 und 50 Gew.-%, bevorzugt grösser als 10 Gew.-%, ist.

4. Wässerige Dispersion nach Ansprüchen 1 bis 3, **dadurch gekennzeichnet, dass** die BET-Oberfläche zwischen 50 und 90 m²/g liegt.

5. Wässerige Dispersion nach den Ansprüchen 1 bis 4, **dadurch gekennzeichnet, dass** sie oberflächenaktive Substanzen und/oder Dispergierhilfsmittel enthält.

6. Verfahren zur Herstellung der wässerigen Dispersion gemäss den Ansprüchen 1 bis 5, **dadurch gekennzeichnet, dass** man ein mittels eines Aerosols mit Aluminiumoxid dotiertes Siliciumdioxid in einem wässerigem Medium mit einem Energieeintrag von mindestens 200 KJ/m³ dispergiert.

7. Verfahren zur Herstellung der wässerigen Dispersion nach Anspruch 6, **dadurch gekennzeichnet, dass** zur Dispergierung ein Hochdruckhomogenisator verwendet wird.

8. Verwendung der wässerigen Dispersion gemäss den Ansprüchen 1 bis 5 zum chemisch-mechanischen Polieren von oxidischen Oberflächen, bevorzugt Siliciumdioxid.
